# EUROPÄISCHE PATENTANMELDUNG

(11) **EP 4 838 232 A1**
(43) Veröffentlichungstag der Anmeldung: **11.11.2026**
(21) Anmeldenummer: 26173564.1
(22) Anmeldetag: 21.04.2026
(51) Int. Cl.: G01R 31/08

(54) **VERFAHREN ZUR DETEKTION EINER FEHLERFREIEN ODER FEHLERBEHAFTETEN ENERGIEVERSORGUNGSSTRECKE EINER OBERLEITUNGSANLAGE**

(30) Priorität: 08.05.2025 DE 102025117804
(71) Anmelder: Siemens Mobility GmbH, 80997 München (DE)
(72) Erfinder: Dittmer, Dr. Björn, 91058 Erlangen (DE); Drücke, Joshua, 91058 Erlangen (DE); Ullmann, Hans, 91058 Erlangen (DE)
(74) Vertreter: Siemens Patent Attorneys

(57) **Zusammenfassung**

Die Erfindung betrifft ein Verfahren, mittels welchem festgestellt werden kann, ob eine Energieversorgungsstrecke einer Oberleitungsanlage insbesondere einer Fahrleitungsanlage für schienengebundene Fahrzeuge fehlerfrei oder fehlerbehaftet ist, wobei hierzu der Phasenwinkel zwischen Spannung und Strom oder die Lastimpedanz aus Spannung und Strom ausgewertet wird.

## Beschreibung

Die Erfindung betrifft ein Verfahren zur Detektion einer fehlerfreien oder fehlerbehafteten Energieversorgungsstrecke einer Oberleitungsanlage.

Bei Fahrleitungsanlagen, insbesondere bei Fahrleitungsanlagen für schienengebundene Fahrzeuge, die beispielsweise mit einer Bahnenergieversorgung mit 16,7 Hz mit Energie versorgt werden etc., wird nach einer Schutzauslösung, beispielsweise durch einen Kurzschluss etc., die eine Abschaltung der Energieversorgung der entsprechenden Oberleitungs- bzw. Energieversorgungsstrecke zur Folge hat, eine Leitungsprüfung der entsprechenden Energieversorgungsstrecke durchgeführt, um festzustellen, ob ein permanenter Fehler vorliegt. Eine Wiedereinschaltung der Energieversorgung für die betreffende Energieversorgungsstrecke der Oberleitungs- bzw. Fahrleitungsanlage erfolgt in der Regel erst, nachdem die Leitungsprüfung ein positives Ergebnis liefert, d.h. wenn durch das Prüfverfahren festgestellt wurde, dass die betroffene Leitung bzw. Energieversorgungsstrecke wieder fehlerfrei ist, und insbesondere der Fehler, der zur Schutzauslösung geführt hat, nicht mehr vorliegt. Dies ist üblicherweise bei sogenannten nicht permanenten Fehlern der Fall. So ist beispielsweise das vorübergehende Überbrücken einer Isolationsstrecke durch einen Vogel etc. typischerweise kein permanenter Fehler. Solche Fehler treten nur vorübergehend auf und sind nach einer Schutzauslösung bzw. Schutzabschaltung in der Regel nach kurzer bzw. sehr kurzer Zeit nicht mehr vorhanden, wodurch bei Wiedereinschaltung der Energieversorgung auf eine dann wieder fehlerfreie Leitung geschaltet werden würde. Dagegen ist beispielsweise eine abgerissene Oberleitung mit Erdberührung etc. im Gegensatz dazu ein permanenter Fehler, wodurch in diesen Fällen bei Wiedereinschaltung der Energieversorgung auf eine nach wie vor fehlerbehaftete Leitung geschaltet werden würde, was wiederum zur sofortigen erneuten Schutzauslösung und somit zur erneuten Abschaltung der Energieversorgung der entsprechenden Energieversorgungsstrecke führen würde. Mit der Durchführung einer Leitungsprüfung wird demzufolge bei negativem Ergebnis eine Wiederzuschaltung, die dann eine sofortige, erneute Abschaltung nach sich ziehen würde, verhindert und somit auch ein erhöhter Verschleiß und/oder eine Beschädigung von Teilen des betroffenen Kettenwerks aufgrund von hohen Kurzschlussströmen insbesondere bei einer Bahnenergieversorgung mit 16,7 Hz und der dadurch verursachten hohen Kräfte und thermischen Erwärmung vermieden.

Zur Durchführung von solchen Leitungs- bzw. Streckenprüfungen, insbesondere Energieversorgungsstrecken etc., wird hierzu üblicherweise für eine begrenzte Zeit die Sammelschienenspannung mit Hilfe einer Prüfeinrichtung auf die Oberleitung gebracht, ohne einen großen Kurzschlussstrom zu verursachen.

Ein hierzu häufig verwendetes Verfahren ist eine Energieversorgungsstreckenprüfung mit einer Prüfeinrichtung mit einem Widerstand. Dazu wird während eines Prüfzyklus Strom und/oder Spannung der betroffenen Strecke, insbesondere Energieversorgungsstrecke etc., von der Prüfeinrichtung gemessen und ausgewertet. Zur Unterscheidung zwischen fehlerfreier und permanent fehlerbehafteter Leitung bzw. Strecke, insbesondere Energieversorgungsstrecke etc., wird jeweils eine eindeutige Entscheidungsschwelle benötigt. Als Grundlage hierfür wird bisher entweder ein gemessener Effektivwert von Strom und/oder Spannung oder alternativ der Wert eines Integrals von Strom und/oder Spannung über einen definierten Zeitraum herangezogen.

Nachteilig ist, dass mittels solcher Verfahren nicht in allen Fällen eindeutig und zweifelsfrei festgestellt bzw. detektiert werden kann, ob die entsprechende Leitung bzw.

Energieversorgungsstrecke einer Oberleitungsanlage tatsächlich fehlerfrei oder fehlerbehaftet ist. So steigt insbesondere bei Streckenabschnitten mit vielen streckenseitig verbauten Kabeln, beispielsweise bei langen Eisenbahntunneln etc., die Kapazität C der betreffenden Strecke und damit auch der kapazitive Ladestrom auch bei zugeschalteter, fehlerfreier und lastloser Strecke an. Dies kann dann dazu führen, dass der kapazitive Ladestrom einer fehlerfreien Leitung eine ähnlich große Amplitude aufweist, wie der Fehlerstrom bei einer permanent fehlerbehafteten Leitung mit vorgeschaltetem Prüfwiderstand: Somit ist durch eine solche Auswertung des Stroms keine eindeutige Zuordnung bzw. Entscheidung möglich. Ähnliches gilt für eine Auswertung der Spannung. Neben diesen Fällen, bei denen die betreffende Leitung bzw. Energieversorgungsstrecke eine hohe Kapazität aufweist, kann auch der Anschluss von zahlreichen Nebenverbrauchern an die Fahrleitung bzw. Energieversorgungsstrecke im betreffenden Streckenabschnitt ähnliche Auswirkungen hervorrufen.

In diesen Fällen kann somit mit den bisherigen Verfahren auf Basis eines Schwellwerts nicht bzw. nicht eindeutig festgestellt bzw. detektiert werden, ob die entsprechende Leitung bzw. Energieversorgungsstrecke einer Oberleitungsanlage fehlerfrei oder fehlerbehaftet ist.

Der Erfindung liegt deshalb die Aufgabe zugrunde, ein verbessertes Verfahren zur Detektion einer fehlerfreien oder fehlerbehafteten Energieversorgungsstrecke einer Oberleitungsanlage anzugeben.

Diese Aufgabe wird erfindungsgemäß durch die Merkmale des unabhängigen Patentanspruchs 1 gelöst. Weiterbildungen und Ausgestaltungen der Erfindung finden sich in den Merkmalen der abhängigen Patentansprüche wieder.

Dazu weist das erfindungsgemäße Verfahren folgende Schritte auf:
- Prüfung der Energieversorgungsstrecke durch eine Prüfeinrichtung mit einem Widerstand;
- Messung von jeweils zugehörigen Strom- und Spannungswerten der Energieversorgungsstrecke während der Prüfung der Energieversorgungsstrecke durch die Prüfeinrichtung;
- Speicherung der während der Prüfung der Energieversorgungsstrecke durch die Prüfeinrichtung jeweils gemessenen, zugehörigen Strom- und Spannungswerte;
- Festlegung wenigstens einer Entscheidungsschwelle zwischen einer fehlerfreien und einer fehlerbehafteten Energieversorgungsstrecke der Oberleitungsanlage in Abhängigkeit der während der Prüfung der Energieversorgungsstrecke durch die Prüfeinrichtung jeweils gemessenen, zugehörigen Strom- und Spannungswerte, wobei die wenigstens eine Entscheidungsschwelle basierend auf dem Phasenwinkel oder der Impedanz zwischen zugehörigen Strom- und Spannungswerten festgelegt wird;
- Berechnung des jeweiligen Phasenwinkels zwischen den, während der Prüfung der Energieversorgungsstrecke durch die Prüfeinrichtung jeweils gemessenen, zugehörigen Strom- und Spannungswerten und/oder Berechnung der jeweiligen Impedanz aus den, während der Prüfung der Energieversorgungsstrecke durch die Prüfeinrichtung jeweils gemessenen, zugehörigen Strom- und Spannungswerten;
- Vergleich des berechneten Phasenwinkels und/oder der berechneten Impedanz mit der jeweils festgelegten, wenigstens einen Entscheidungsschwelle;
- Detektion der fehlerfreien oder fehlerbehafteten Energieversorgungsstrecke der Oberleitungsanlage basierend auf dem Ergebnis des Vergleichs des berechneten Phasenwinkels oder der berechneten Impedanz mit der jeweils festgelegten, wenigstens einen Entscheidungsschwelle, wobei eine fehlerfreie Energieversorgungsstrecke bei Unterschreiten der Entscheidungsschwelle vorliegt.

Vorteilhafterweise wird dadurch eine zweifelsfreie Unterscheidung zwischen fehlerbehafteter und fehlerfreier Strecke in allen Fällen, insbesondere bei Streckenabschnitten mit vielen streckenseitig verbauten Kabeln, beispielsweise bei langen Eisenbahntunneln oder bei Streckenabschnitten, bei denen zahlreiche Nebenverbraucher an die Fahr- bzw. Oberleitung bzw. Energieversorgungsstrecke angeschlossen sind etc., ermöglicht.

Während einer Leitungsprüfung der entsprechenden Energieversorgungsstrecke fließt bei fehlerfreier Strecke ein im Wesentlichen kapazitiver Strom, welcher der Spannung vorauseilt, so dass ein Phasenwinkel von mindestens kleiner -5°, also signifikant weniger als Null Grad zwischen Strom und Spannung vorliegt. Während einer Leitungsprüfung bei fehlerbehafteter Strecke fließt dagegen ein rein ohmscher bis leicht induktiv-ohmscher Strom, der bezüglich der Spannung im Wesentlichen keine Phasenverschiebung, also im Wesentlichen einen Phasenwinkel von Null Grad aufweist. Somit ist eine eindeutige und aussagekräftige Entscheidungsschwelle zwischen fehlerbehafteter und fehlerfreier Strecke bzw. Energieversorgungsstrecke auf Basis des Phasenwinkels zwischen zugehörigen Strom- und Spannungswerten festlegbar. So kann beispielsweise eine Entscheidungsschwelle bei einem Phasenwinkel in einem Bereich zwischen 0° und -3° festgelegt werden. Andere sinnvolle Bereiche für die Entscheidungsschwelle sind selbstverständlich ohne Beschränkung ebenfalls mit umfasst. Durch die Berechnung und anschließende Auswertung des jeweiligen Phasenwinkels zwischen Spannung und Strom aus den jeweiligen, während der Prüfung der Energieversorgungsstrecke durch die Prüfeinrichtung gemessenen, zugehörigen Spannungs- und Stromwerten, der sich in beiden Fällen, eine fehlerfreie, d.h. der Phasenwinkel ist negativ und mindestens kleiner als -5°, bzw. eine fehlerbehaftete Energieversorgungsstrecke bzw. Leitung, d.h. der Phasenwinkel ist im Wesentlichen gleich 0°, jeweils signifikant unterscheidet, ist somit ein Unterschreiten der festgelegten Entscheidungsschwelle eindeutig feststellbar und erlaubt demzufolge eine zweifelsfreie Entscheidung, ob eine fehlerbehaftete oder eine fehlerfreie Strecke bzw. Energieversorgungsstrecke vorliegt. Somit ist erfindungsgemäß die eindeutige Detektion einer fehlerfreien oder fehlerbehafteten Energieversorgungsstrecke der betreffenden Oberleitungsanlage im Gegensatz zu bisherigen Verfahren möglich.

Eine alternative, davon unabhängige Methode zur eindeutigen Detektion einer fehlerfreien oder fehlerbehafteten Energieversorgungsstrecke ergibt sich aus der Berechnung der Fehler- bzw. Lastimpedanz und somit des Last- bzw. Kurzschlusswinkels in der komplexen R/X-Ebene aus den gemessenen Werten von Strom und Spannung. Während einer Leitungsprüfung der entsprechenden Energieversorgungsstrecke fließt bei fehlerfreier Strecke, wie oben bereits beschrieben, ein im Wesentlichen kapazitiver Strom. In diesem Fall liegt die, aus den jeweiligen, während der Prüfung der Energieversorgungsstrecke durch die Prüfeinrichtung gemessenen, zugehörigen Spannungs- und Stromwerten, berechnete Impedanz zwischen Spannung und Strom im vierten Quadranten der komplexen R/X-Ebene. Während einer Leitungsprüfung bei fehlerbehafteter Strecke, bei dem ein rein ohmscher bis induktiv-ohmscher Strom fließt, liegt die berechnete Impedanz zwischen Spannung und Strom dagegen im ersten Quadranten der komplexen R/X-Ebene. Somit ist eine eindeutige und aussagekräftige Entscheidungsschwelle zwischen fehlerbehafteter und fehlerfreier Strecke bzw. Energieversorgungsstrecke auch auf Basis der Impedanz, insbesondere der Fehler- bzw. Lastimpedanz zwischen zugehörigen Strom- und Spannungswerten festlegbar. So kann beispielsweise die R-Achse der komplexen R/X-Ebene als Entscheidungsschwelle festgelegt werden. Durch die Berechnung und anschließende Auswertung der jeweiligen Impedanz zwischen Spannung und Strom aus den jeweiligen, während der Prüfung der Energieversorgungsstrecke durch die Prüfeinrichtung gemessenen, zugehörigen Spannungs- und Stromwerten, die sich in beiden Fällen, eine fehlerfreie, d.h. die berechneten Impedanzwerte liegen im vierten Quadranten unterhalb der R-Achse der komplexen R/X-Ebene, bzw. eine fehlerbehaftete Energieversorgungsstrecke bzw. Leitung, d.h. die berechneten Impedanzwerte liegen im ersten Quadranten auf oder oberhalb der R-Achse der komplexen R/X-Ebene, jeweils signifikant unterscheidet, ist somit ein Unterschreiten der festgelegten Entscheidungsschwelle ebenfalls eindeutig feststellbar und erlaubt demzufolge eine zweifelsfreie Entscheidung, ob eine fehlerbehaftete oder eine fehlerfreie Strecke bzw. Energieversorgungsstrecke vorliegt. Somit ist erfindungsgemäß auch auf diese Weise die eindeutige Detektion einer fehlerfreien oder fehlerbehafteten Energieversorgungsstrecke der betreffenden Oberleitungsanlage im Gegensatz zu bisherigen Verfahren möglich.

Nach einer weiteren Ausführungsform der Erfindung beträgt der Widerstand der Prüfeinrichtung höchstens 10kOhm. Auf diese Weise ist gewährleistet, dass der, durch die Leitungs- bzw. Streckenprüfung, bei der üblicherweise die Sammelschienenspannung mit Hilfe der Prüfeinrichtung für die Zeit zur Durchführung der Prüfung auf die Oberleitung gebracht wird, verursachte Kurzschlussstrom sicher die einzuhaltenden Werte nicht überschreitet.

Nach einer weiteren besonders bevorzugten Ausführungsform der Erfindung erfolgt die Detektion einer fehlerfreien oder fehlerbehafteten Energieversorgungsstrecke der Oberleitungsanlage basierend auf dem Ergebnis des Vergleichs des berechneten Phasenwinkels und der berechneten Impedanz mit der jeweils festgelegten Entscheidungsschwelle. Auf diese Weise wird die jeweilige individuelle Entscheidung, ob eine fehlerbehaftete oder eine fehlerfreie Strecke bzw. Energieversorgungsstrecke vorliegt, noch sicherer bzw. zutreffender.

Nach einer weiteren Ausführungsform der Erfindung erfolgt die Messung der jeweils zugehörigen Strom- und Spannungswerte der Energieversorgungsstrecke während der Prüfung der Energieversorgungsstrecke durch die Prüfeinrichtung über wenigstens eine Viertel-Periode der Betriebsfrequenz der Energieversorgung. Somit ist gewährleistet, dass solche Strecken- bzw. Leitungsprüfungen auch durch elektronische Schalter, also mittels Leistungselektronik durchgeführt werden können, da das erfindungsgemäße Verfahren auch bei sehr kurzen Prüfzyklen mit entsprechend kurzen Messfenstern, beispielsweise von ca. 15 ms, was einer Viertel-Periode bei 16,7 Hz entspricht, eine eindeutige Entscheidung, ob eine fehlerbehaftete oder eine fehlerfreie Strecke bzw. Energieversorgungsstrecke vorliegt, ermöglicht.

Nach einer weiteren bevorzugten Ausführungsform der Erfindung erfolgt die Messung der jeweils zugehörigen Strom- und Spannungswerte der Energieversorgungsstrecke während der Prüfung der Energieversorgungsstrecke durch die Prüfeinrichtung über mehrere Perioden der Betriebsfrequenz der Energieversorgung. Auf diese Weise ist das Ergebnis einer Strecken- bzw. Leitungsprüfung besonders belastbar und aussagekräftig und somit die Entscheidung, ob eine fehlerbehaftete oder eine fehlerfreie Strecke bzw. Energieversorgungsstrecke vorliegt, überproportional zutreffend.

Nach einer weiteren bevorzugten Ausführungsform der Erfindung wird bei der Festlegung der Entscheidungsschwelle zwischen einer fehlerfreien und einer fehlerbehafteten Energieversorgungsstrecke der Oberleitungsanlage basierend auf der Impedanz eine Toleranzabweichung der Messwerte berücksichtigt. Besonders bevorzugt beträgt die Toleranzabweichung der Messwerte 5%.

Auf diese Weise wird vorteilhafterweise ein Sicherheitspuffer berücksichtigt, aufgrund dessen die Anzahl der zutreffenden Entscheidungen auf Basis der Ergebnisse einer Strecken- bzw. Leitungsprüfung, ob eine fehlerbehaftete oder eine fehlerfreie Strecke bzw. Energieversorgungsstrecke vorliegt, signifikant weiter ansteigt, d.h., dass die Auswertung der Ergebnisse der Strecken- bzw. Leitungsprüfung entsprechend häufiger zur richtigen Entscheidung führt.

Nach einer weiteren bevorzugten Ausführungsform der Erfindung ist die Oberleitungsanlage eine Oberleitungsanlage für schienengebundene Fahrzeuge.

Zusammengefasst betrifft die Erfindung ein Verfahren, mittels welchem festgestellt werden kann, ob eine Energieversorgungsstrecke einer Oberleitungsanlage, insbesondere einer Oberleitungsanlage für schienengebundene Fahrzeuge, insbesondere einer Oberleitungsanlage mit hohem Kabelanteil, fehlerfrei oder fehlerbehaftet ist, wobei hierzu erfindungsgemäß der Phasenwinkel zwischen Spannung und Strom oder die Impedanz, insbesondere die Fehler- bzw. Lastimpedanz zwischen Spannung und Strom ausgewertet wird.

Im Weiteren werden bevorzugte Ausführungsbeispiele der Erfindung mit Bezugnahme auf die Zeichnungen näher erläutert. Es zeigen:
Fig. 1 ein Ersatzschaltbild einer Prüfanordnung gemäß dem Stand der Technik;
Fig. 2 ein Diagramm eines beispielhaften Messverlaufs einer Spannung über die Zeit bei einer Leitungsprüfung, sowie darübergelegt den zugehörigen Messverlauf des Stroms bei einer fehlerbehafteten Strecke sowie bei einer fehlerfreien Strecke und
Fig. 3 eine Darstellung verschiedener Fehler- bzw. Lastimpedanzwerte in einer komplexen R/X-Ebene.

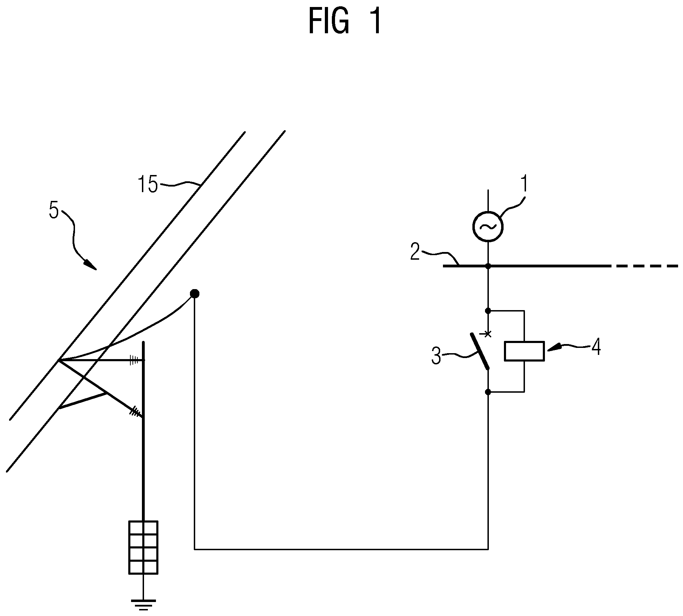

Figur 1 zeigt ein Ersatzschaltbild einer Prüfanordnung gemäß dem Stand der Technik. Hat ein Fehler auf einer Energieversorgungsstrecke 15 einer Fahrleitungs- bzw. Oberleitungsanlage 5 für schienengebundene Fahrzeuge, beispielsweise durch einen Kurzschluss etc., zu einer Schutzauslösung, d.h. einer Abschaltung der mittels der Energieeinspeisung 1 gewährleisteten Energieversorgung der entsprechenden Energieversorgungsstrecke 15 durch Öffnen des Leistungsschalters 3 geführt, wird eine Leitungsprüfung der entsprechenden Energieversorgungsstrecke 15 durchgeführt, um festzustellen, ob ein permanenter Fehler vorliegt.

Der Ablauf der Leitungsprüfung ist nach der Abschaltung üblicherweise wie folgt:
1. Einschalten der Prüfeinrichtung 4 mit Widerstand mittels einem darin enthaltenen Schaltgerät bzw. entsprechender Leistungselektronik.
   Dabei wird üblicherweise die Sammelschienenspannung der Sammelschiene 2 mit Hilfe der Prüfeinrichtung 4 für die Zeit zur Durchführung der Prüfung auf die Energieversorgungsstrecke 15 gebracht.
2. Messung von Strom und Spannung während der Leitungsprüfung mittels der Prüfeinrichtung 4.
3. Abschalten der Prüfeinrichtung 4 mittels dem, darin enthaltenen Schaltgerät bzw. der entsprechenden Leistungselektronik.
4. Auswertung der Messdaten.

Anschließend erfolgt bei positivem Ergebnis der Auswertung der Messdaten eine Wiederzuschaltung der Leitung bzw. der Energieversorgungsstrecke 15 der Oberleitungsanlage 5 an die Energieeinspeisung 1.

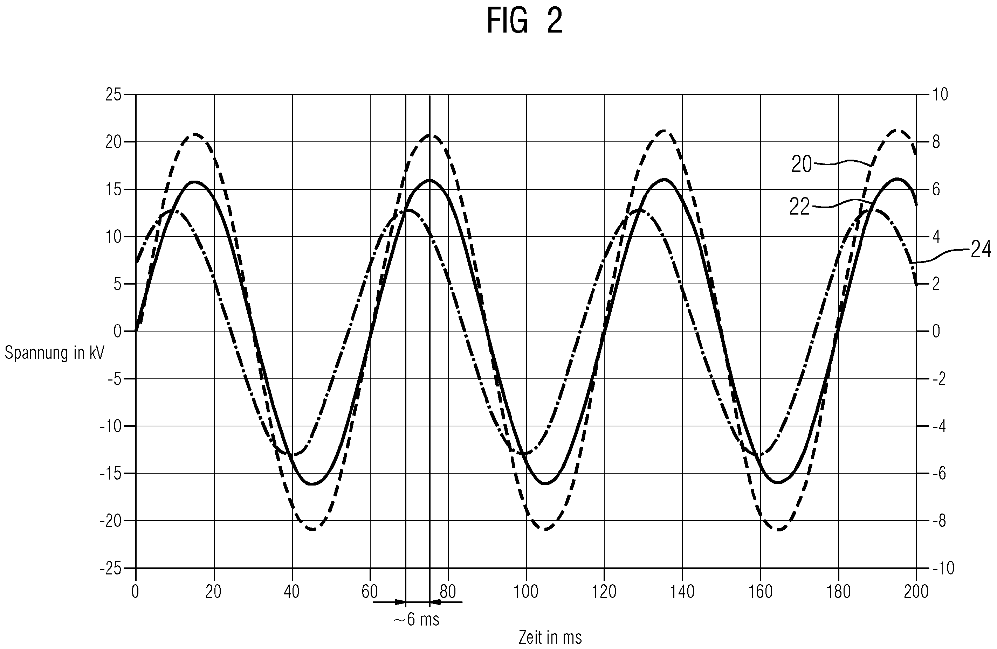

Figur 2 zeigt ein Diagramm eines beispielhaften Messverlaufs einer Spannung 20 in Kilovolt (kV) über die Zeit in Millisekunden (ms) bei einer Leitungsprüfung, sowie darübergelegt den zugehörigen Messverlauf 22 des Stroms bei einer fehlerbehafteten Strecke sowie den zugehörigen Messverlauf 24 bei einer fehlerfreien Strecke.

Die Messverläufe charakterisieren eine Leitungs- bzw. Streckenprüfung vorliegend beispielhaft mittels einer Prüfeinrichtung mit einem 3,3 kOhm Prüfwiderstand und einer Kapazität von 4 µF eines elektrischen Bahnenergieversorgungssystems mit 16,7 Hz Nennfrequenz und einer Nennspannung von 15 kV, wie diese insbesondere bei Oberleitungs- bzw. Energieversorgungsstrecken von Oberleitungsanlagen auftreten, bei denen vergleichsweise viele streckenseitig verbaute Kabel, beispielsweise bei langen Eisenbahntunneln etc., vorliegen und wodurch die Kapazität C der betreffenden Strecken und somit der kapazitive Ladestrom auch bei fehlerfreier und lastloser Strecke steigt.

So ergibt sich bei der Prüfung einer fehlerfreien Strecke der Messverlauf 24 des zugehörigen Stroms Iₗₑₑₙ der der Spannung U 20 voreilt, wobei in diesem Fall im Wesentlichen nur kapazitiver Ladestrom fließt. Wie aus Figur 2 ersichtlich, ergibt sich bei einer Bahnenergieversorgung von 16,7 Hz, bei einer Messung über eine volle Periode der Betriebsfrequenz, beispielsweise von 60 ms (entspricht 360°), aus der voreilenden Phasenverschiebung des Stroms Iₗₑₑᵣ 24 von etwa 6 ms gegenüber der Spannung U 20 ein entsprechender Phasenwinkel von -36°.

Bei der Prüfung einer fehlerbehafteten Strecke mit einem permanent bestehenden Fehler, beispielsweise einem Kurzschluss, auch short circuit (sc) genannt etc., auf der Oberleitungs- bzw. Energieversorgungsstrecke der Oberleitungsanlage, bei der in diesem Fall ein größtenteils ohmscher bis leicht induktiver Strom I_{sc} fließt, ergibt sich dagegen ein Messverlauf 22 des zugehörigen Stroms I_{sc}, der der Spannung U 20 nicht voreilt, sondern im Wesentlichen keine Phasenverschiebung zur Spannung U 20 aufweist. Somit liegt zwischen dem Strom I_{sc} 22 und der Spannung U 20 ein Phasenwinkel von näherungsweise 0° vor.

Aufgrund der signifikanten Unterschiede des Phasenwinkels zwischen fehlerbehafteter und fehlerfreier Strecke bzw. Energieversorgungsstrecke kann auf Basis des Phasenwinkels zwischen zugehörigen Strom- und Spannungswerten eine eindeutige und aussagekräftige Entscheidungsschwelle, vorliegend beispielsweise bei einem Phasenwinkel in einem Bereich zwischen 0° und -3° festgelegt werden. Durch die Berechnung und anschließende Auswertung des jeweiligen Phasenwinkels zwischen Spannung U 20 und Strom I 22, 24 aus den jeweiligen, während der Prüfung der Energieversorgungsstrecke durch die Prüfeinrichtung gemessenen, zugehörigen Spannungs- und Stromwerten, ist somit ein Unterschreiten der festgelegten Entscheidungsschwelle eindeutig feststellbar. Somit ergibt sich bezüglich des Messverlaufs 22 ein Phasenwinkel von etwa 0° und demzufolge die zweifelsfreie und eindeutige Entscheidung, dass bezüglich des Messverlaufs 22 eine fehlerfreie Strecke bzw. Energieversorgungsstrecke vorliegt. Im Gegensatz dazu ergibt sich bezüglich des Messverlaufs 24, wie oben bereits beschrieben, ein Phasenwinkel von etwa -36°, der die Entscheidungsschwelle also deutlich unterschreitet, und demzufolge die zweifelsfreie und eindeutige Entscheidung, dass bezüglich des Messverlaufs 24 eine mit einem permanenten Fehler behaftete Strecke bzw. Energieversorgungsstrecke vorliegt.

Somit sind eine fehlerfreie oder fehlerbehaftete Energieversorgungsstrecke der betreffenden Oberleitungsanlage im Gegensatz zu bisherigen Verfahren eindeutig detektierbar.

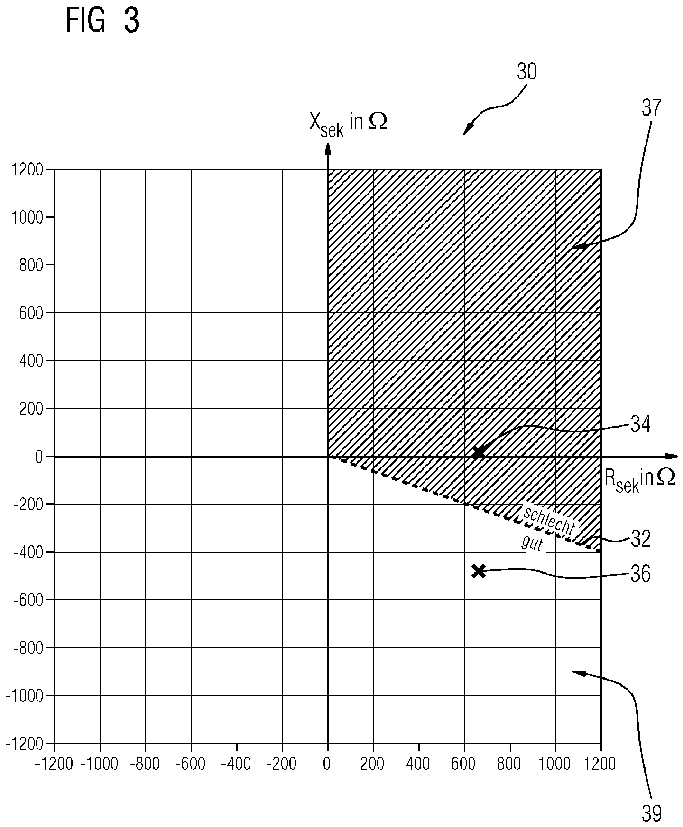

Figur 3 zeigt eine beispielhafte Darstellung verschiedener Fehler- bzw. Lastimpedanzwerte 34, 36 in der komplexen R/X-Ebene 30. Alternativ zur Bestimmung bzw. Berechnung des Phasenwinkels zwischen Strom I und Spannung U gemäß Ausführungsbeispiel der Erfindung wie in Figur 2 beschrieben, kann auch die Bestimmung bzw. Berechnung der jeweiligen Impedanz, insbesondere der Fehler- bzw. Lastimpedanz, also des Last- bzw. Kurzschlusswinkels, aus den, während der Prüfung der Energieversorgungsstrecke durch die Prüfeinrichtung gemessenen, jeweils zugehörigen Werten von Strom I und Spannung U der Energieversorgungsstrecke erfolgen, welche in der komplexen R/X-Ebene 30 dargestellt wird.

Während der Leitungsprüfung der entsprechenden Energieversorgungsstrecke unter den genannten Randbedingungen bzw. Fällen fließt, wie bereits beschrieben, bei fehlerfreier Strecke ein im Wesentlichen kapazitiver Strom. In diesem Fall liegt die, aus den jeweiligen, während der Prüfung der Energieversorgungsstrecke durch die Prüfeinrichtung gemessenen, zugehörigen Spannungs- und Stromwerten, berechnete Impedanz zwischen Spannung und Strom im vierten Quadranten 39 der komplexen R/X-Ebene 30. Während der Leitungsprüfung bei fehlerbehafteter Strecke, bei dem ein rein ohmscher bis induktiv-ohmscher Strom fließt, liegt die berechnete Impedanz zwischen Spannung und Strom dagegen im ersten Quadranten 37 der komplexen R/X-Ebene 30. Aufgrund der signifikanten Unterschiede der Impedanzwerte zwischen fehlerbehafteter und fehlerfreier Strecke bzw. Energieversorgungsstrecke könnte auf Basis der Impedanz, insbesondere der Fehler- bzw. Lastimpedanz aus den zugehörigen Strom- und Spannungswerten vorliegend beispielsweise die R-Achse der komplexen R/X-Ebene 30 als eindeutige und aussagekräftige Entscheidungsschwelle festgelegt werden.

Um die Aussagekraft bzw. Richtigkeit der Entscheidungen weiter zu verbessern bzw. zu erhöhen, werden aus Sicherheitsgründen Messtoleranzen, Sicherheitspuffer etc. berücksichtigt und im Ergebnis die als gestrichelte Linie dargestellte Entscheidungsschwelle 32, abweichend von der R-Achse der komplexen R/X-Ebene 30, ausgehend vom Koordinatennullpunkt in den vierten Quadranten 39 der komplexen R/X-Ebene 30 verschoben, so dass sicherheitshalber auch bei Impedanzwerten, die sich zwischen der R-Achse und der Entscheidungsschwelle 32 bzw. auf der Entscheidungsschwelle 32, also bereits im vierten Quadranten 39 befinden, noch von einer fehlerbehafteten Leitung bzw. Energieversorgungsstrecke ausgegangen wird und erst bei Ergebnissen bzw. Impedanzwerten, die sich im vierten Quadranten 39 unterhalb der gestrichelten Entscheidungsschwelle 32 befinden, also die Entscheidungsschwelle 32 eindeutig unterschreiten, sicher von einer fehlerfreien Leitung bzw. Energieversorgungsstrecke ausgegangen wird. Vorliegend entspricht die Entscheidungsschwelle 32 einer Toleranzabweichung von 5% der Messwerte, was einer Differenz des Phasenwinkels zwischen Strom I und Spannung U von etwa 15° entspricht. Die Anzahl der zutreffenden Entscheidungen auf Basis der Entscheidungsschwelle 32, ob eine fehlerbehaftete oder eine fehlerfreie Strecke bzw. Energieversorgungsstrecke vorliegt, wird somit signifikant erhöht, d.h., dass die Auswertung der Ergebnisse der Strecken- bzw. Leitungsprüfung entsprechend häufiger zur richtigen Entscheidung führt.

Somit ergibt sich bezüglich des Impedanzwerts 34, der unmittelbar auf der R-Achse der komplexen R/X-Ebene 30, also eindeutig oberhalb der Entscheidungsschwelle 32 liegt, demzufolge die zweifelsfreie und eindeutige Entscheidung, dass eine mit einem permanenten Fehler behaftete Strecke bzw. Energieversorgungsstrecke vorliegt. Im Gegensatz dazu ergibt sich bezüglich des Impedanzwerts 36, der im vierten Quadranten 39 eindeutig unterhalb der Entscheidungsschwelle 32 liegt, diese also deutlich unterschreitet, demzufolge die zweifelsfreie und eindeutige Entscheidung, dass eine fehlerfreie Strecke bzw. Energieversorgungsstrecke vorliegt.

Somit ist eine zweifelsfreie Unterscheidung der Zustände gut = fehlerfreie Leitung, bzw. Energieversorgungsstrecke, d.h. entsprechende Impedanzwerte liegen unterhalb der Entscheidungsschwelle 32, bzw. schlecht = fehlerbehaftete Leitung bzw. Energieversorgungsstrecke, d.h. entsprechende Impedanzwerte liegen auf oder oberhalb der Entscheidungsschwelle 32, problemlos möglich und demzufolge sind auch auf diese Weise eine fehlerfreie oder fehlerbehaftete Energieversorgungsstrecke der betreffenden Oberleitungsanlage im Gegensatz zu bisherigen Verfahren eindeutig detektierbar.

Die Erfindung ist weiterhin in keiner Weise auf die, in den Figuren 2 und 3 beschriebenen Ausführungsformen beschränkt. Vielmehr sind auch alle möglichen weiteren, sinnvollen Ausführungsformen der Erfindung entsprechend ohne Beschränkung mit umfasst.

*Unabhängig vom grammatikalischen Geschlecht eines bestimmten Begriffes sind Personen mit männlicher, weiblicher oder anderer Geschlechteridentität mit umfasst.*

## Patentansprüche

1. Verfahren zur Detektion einer fehlerfreien oder fehlerbehafteten Energieversorgungsstrecke (15) einer Oberleitungsanlage (5) mit folgenden Schritten:
- Prüfung der Energieversorgungsstrecke (15) durch eine Prüfeinrichtung (4) mit einem Widerstand;
- Messung von jeweils zugehörigen Strom- und Spannungswerten der Energieversorgungsstrecke (15) während der Prüfung der Energieversorgungsstrecke (15) durch die Prüfeinrichtung (4);
- Speicherung der während der Prüfung der Energieversorgungsstrecke (15) durch die Prüfeinrichtung (4) jeweils gemessenen, zugehörigen Strom- und Spannungswerte;
- Festlegung wenigstens einer Entscheidungsschwelle zwischen einer fehlerfreien und einer fehlerbehafteten Energieversorgungsstrecke (15) der Oberleitungsanlage (5) in Abhängigkeit der während der Prüfung der Energieversorgungsstrecke (15) durch die Prüfeinrichtung (4) jeweils gemessenen, zugehörigen Strom- und Spannungswerte, wobei die wenigstens eine Entscheidungsschwelle basierend auf dem Phasenwinkel oder der Impedanz zwischen zugehörigen Strom- und Spannungswerten festgelegt wird;
- Berechnung des jeweiligen Phasenwinkels zwischen den, während der Prüfung der Energieversorgungsstrecke (15) durch die Prüfeinrichtung (4) jeweils gemessenen, zugehörigen Strom- und Spannungswerten und/oder Berechnung der jeweiligen Impedanz aus den, während der Prüfung der Energieversorgungsstrecke (15) durch die Prüfeinrichtung (4) jeweils gemessenen, zugehörigen Strom- und Spannungswerten;
- Vergleich des berechneten Phasenwinkels und/oder der berechneten Impedanz mit der jeweils festgelegten, wenigstens einen Entscheidungsschwelle;
- Detektion der fehlerfreien oder fehlerbehafteten Energieversorgungsstrecke (15) der Oberleitungsanlage (5) basierend auf dem Ergebnis des Vergleichs des berechneten Phasenwinkels oder der berechneten Impedanz mit der jeweils festgelegten, wenigstens einen Entscheidungsschwelle, wobei eine fehlerfreie Energieversorgungsstrecke (15) bei Unterschreiten der Entscheidungsschwelle vorliegt.

2. Verfahren nach Anspruch 1,
**dadurch gekennzeichnet, dass**
der Widerstand der Prüfeinrichtung (4) höchstens 10kOhm beträgt.

3. Verfahren nach Anspruch 1 oder 2,
**dadurch gekennzeichnet, dass**
die Detektion einer fehlerfreien oder fehlerbehafteten Energieversorgungsstrecke (15) der Oberleitungsanlage (5) basierend auf dem Ergebnis des Vergleichs des berechneten Phasenwinkels und der berechneten Impedanz mit der jeweils festgelegten Entscheidungsschwelle erfolgt.

4. Verfahren nach einem der vorherigen Ansprüche,
**dadurch gekennzeichnet, dass**
die Messung der jeweils zugehörigen Strom- und Spannungswerte der Energieversorgungsstrecke (15) während der Prüfung der Energieversorgungsstrecke (15) durch die Prüfeinrichtung (4) über wenigstens eine Viertel-Periode der Betriebsfrequenz der Energieversorgung erfolgt.

5. Verfahren nach Anspruch 4,
**dadurch gekennzeichnet, dass**
die Messung der jeweils zugehörigen Strom- und Spannungswerte der Energieversorgungsstrecke (15) während der Prüfung der Energieversorgungsstrecke (15) durch die Prüfeinrichtung (4) über mehrere Perioden der Betriebsfrequenz der Energieversorgung erfolgt.

6. Verfahren nach einem der vorherigen Ansprüche,
**dadurch gekennzeichnet, dass**
bei der Festlegung der Entscheidungsschwelle zwischen einer fehlerfreien und einer fehlerbehafteten Energieversorgungsstrecke (15) der Oberleitungsanlage (5) basierend auf der Impedanz eine Toleranzabweichung der Messwerte berücksichtigt wird.

7. Verfahren nach Anspruch 6,
**dadurch gekennzeichnet, dass**
die Toleranzabweichung der Messwerte 5% beträgt.

8. Verfahren nach einem der vorherigen Ansprüche,
**dadurch gekennzeichnet, dass**
die Oberleitungsanlage (5) eine Oberleitungsanlage (5) für schienengebundene Fahrzeuge ist.
